# EUROPEAN PATENT APPLICATION

(11) **EP 4 513 570 A1**
(43) Date of publication of application: **26.02.2025**
(21) Application number: 23207098.7
(22) Date of filing: 31.10.2023
(51) Int. Cl.: H01L 29/40, H01L 29/41, H01L 29/78, H01L 29/739, H01L 21/336

(54) **SEGMENTED POLY TRENCH MOSFET WITH IMPROVED SWITCHING PERFORMANCE**

(30) Priority: 21.08.2023 EP 23192390
(71) Applicant: Nexperia B.V., 6534 AB Nijmegen (NL)
(72) Inventor: Hsu, Chih-Wei, Manchester (GB); Brown, Adam, Manchester, SK7 5BJ (GB)
(74) Representative: Pjanovic, Ilija

(57) **Abstract**

A semiconductor power device comprising an active region including a drift region of a first conductivity type, a body region of a second conductivity type provided over the drift region and a trench in contact with the body region and the drift region. The trench comprises a gate conductive region and a segmented source conductive region comprising a first and second part separated by a first insulation region, the second part being arranged between the gate conductive region and the first part of the segmented source conductive region. A width of the second insulation region between each of the sidewalls of the trench and the first part is larger than a width of the second insulation region between each of the sidewalls of the trench and the second part. A height of the second part may be between 0.05 µm and 1/5 of a height of the first part.

## Description

### Technical field

The present disclosure relates to a power semiconductor device and a method of manufacturing a power semiconductor device, particularly but not exclusively, the present disclosure relates to a shield gate trench (SGT) metal-oxide semiconductor field-effect transistor (MOSFET).

### Background

MOSFETs are widely known and used in many applications. In a trench MOSFET, current is conducted vertically from one surface of the MOSFET to the other surface of the MOSFET.

A factor that affects a MOSFET's efficiency in switching between an ON-state, in which the current is vertically conducted, and an OFF-state, in which no current is conducted, includes a charge derived from an inherent capacitance of the MOSFET between a gate conductive region and a drain region of the MOSFET. It is desired to produce a MOSFET with a reduced charge between the gate conductive region and the drain or collector region, in order to improve the switching efficiency of the MOSFET.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a semiconductor power device is presented. The semiconductor power device may include an active region. The active region may include a drift region of a first conductivity type. The active region may further include a body region of a second conductivity type provided over the drift region. The second conductivity type may be opposite to the first conductivity type. The active region may further include a trench in contact with the body region and the drift region. The trench may include a gate conductive region. The trench may further include a segmented source conductive region. The segmented source conductive region may include a first part and a second part. The first part may be separated from the second part by a first insulation region. The second part of the segmented source conductive region may be arranged between the gate conductive region and the first part of the segmented source conductive region. The trench may further include a second insulation region arranged between the segmented source conductive region and sidewalls of the trench. The trench may further include a third insulation region arranged between the segmented source conductive region and the gate conductive region. The segmented source conductive region may be configured such that a first width of the second insulation region between each of the sidewalls of the trench and the first part of the segmented source conductive region is larger than a second width of the second insulation region between each of the sidewalls of the trench and the second part of the segmented source conductive region.

In an embodiment, the segmented source conductive region may be configured such that the second part of the segmented source conductive region extends in a direction across the sidewalls of the trench and the first part of the segmented source conductive region extends in a direction parallel to the sidewalls of the trench.

In an embodiment, a width of the second part of the segmented source conductive region may be between 0.3 µm and 4.9 µm.

In an embodiment, a width of the first part of the segmented source conductive region may be between 0.05 µm and 1 µm.

In an embodiment, the second width may be between 5% and 95% of the first width.

In an embodiment, the first width may be between 0.1 µm and 2 µm.

In an embodiment, a height of the second part may be between 0.05 µm and 1/5 of a height of the first part of the segmented source conductive region.

In an embodiment, the segmented source conductive region may be configured such that the second width is uniform along the height of the second part the segmented source conductive region or varies along the height of the second part of the segmented source conductive region.

In an embodiment, a shape of the second part of the segmented source conductive region may include at least one of: a quadrilateral shape and/or a rounded shape.

In an embodiment, the semiconductor device may include a MOSFET or an insulated-gate bipolar transistor (IGBT).

According to an aspect of the present disclosure, a method of manufacturing an active region of a semiconductor power device is presented. The method of manufacturing the active region of the semiconductor power device may include forming a trench in a semiconductor region. The method may further include forming a first insulation region in the trench. The method may further include forming a segmented source conductive region in the trench such that the second insulation region is arranged between the segmented source conductive region and sidewalls of the trench. The segmented source conductive region may include a first part and a second part. The segmented source conductive region may be formed such that the first part is separated from the second part by a first insulation region. The segmented source conductive region may be formed such that a first width of the second insulation region between each of the sidewalls of the trench and the first part of the segmented source conductive region is larger than a second width of the second insulation region between each of the sidewalls of the trench and the second part of the segmented source conductive region. The method may further include forming a third insulation region on the second part of the segmented source conductive region. The method may further include forming a gate conductive region in the trench such that the second part of the segmented source conductive region is arranged between the gate conductive region and the first part of the segmented source conductive region.

In an embodiment, a height of the second part may be between 0.05 µm and 1/5 of a height of the first part of the segmented source conductive region.

In an embodiment, forming the segmented source conductive region in the trench may include forming the first part of the segmented source conductive region. Forming the first part of the segmented source conductive region may include depositing a layer of conductive material on the layer of insulating material and partially removing the layer of conductive material such that a height of the layer of conductive material is less than a height of the trench. Forming the first part of the segmented source conductive region may further include partially removing the layer of insulating material to expose a part of the layer of conductive material. Forming the first part of the segmented source conductive region may further include removing the exposed part of the layer of conductive material to form a cavity or recess in an upper part of the trench.

In an embodiment, forming the segmented source conductive region in the trench may include forming the second part of the segmented source conductive region. Forming the second part of the segmented source conductive region may include creating a layer of insulating material in the cavity or recess formed in the upper part of the trench. The layer of insulating material may cover the first part of the segmented source conductive region. Forming the second part of the segmented source conductive region may further include depositing a layer of conductive material in the cavity or recess formed in the upper part of the trench. Forming the second part of the segmented source conductive region may further include partially removing the layer of conductive material to form the second part of the segmented source conductive region.

According to an aspect of the present disclosure, a method of manufacturing a semiconductor power device is presented. The method of manufacturing the semiconductor power device may include manufacturing an active region according to the method of manufacturing an active region of a semiconductor power device having one or more of the above-described features.

### Brief description of the Drawings

Embodiments of the present disclosure will now be described, by way of example only, with reference to the accompanying schematic drawings in which corresponding reference symbol indicate corresponding parts, in which:
Fig. 1 shows schematically a cross-section of an active area of a semiconductor device;
Fig. 2 schematically shows a cross section of an active region of a semiconductor device according to an embodiment of the disclosure;
Fig. 3 schematically shows an exemplary segmented trench shield of the device of Fig. 2;
Figs. 4 to 6 each schematically show an exemplary shape of a second part of the segmented trench shield of Fig. 2 or Fig. 3; and
Fig. 7 illustrates steps of a method of manufacturing an active region of a semiconductor power device according to an embodiment of the disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

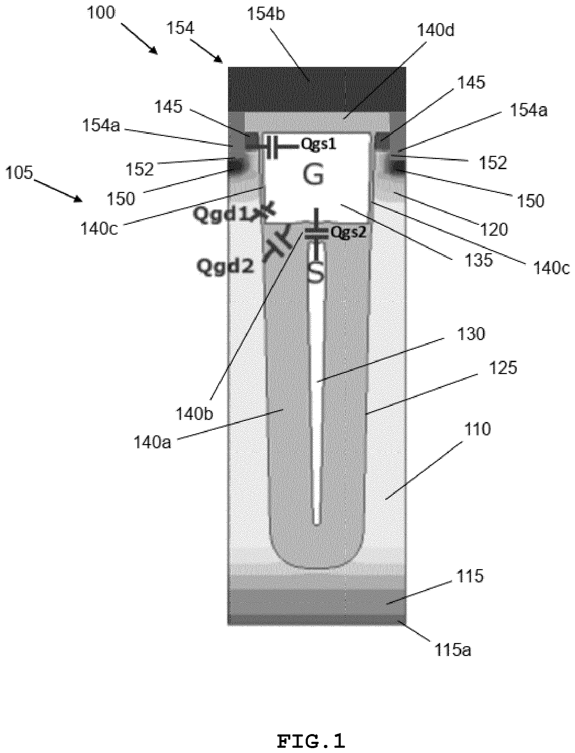

Fig. 1 shows schematically a cross-section of an active area 105 of a semiconductor device 100. The active region 105 shown in Fig. 1 may be considered as a unit cell, which may be repeated, e.g., thousands of times in the device 100. In the examples described herein, the device is a silicon-based shield gate trench MOSFET. However, it will be appreciated that the device may comprise one or more alternative semiconductor materials. For example, the device may alternatively be silicon carbide (SiC) or Gallium Nitride (GaN) based.

The active area 105 includes a drift region 110 of a first conductivity type. In the embodiment shown in Fig. 1, the drift region 110 comprises an n-type doped semiconductor material. An n-dopant concentration of the drift region 110 may be between about 5 × 10¹⁴ cm-³ and 5 × 10¹⁷ cm⁻³. The drift region 110 may also be referred to as an n-drift region or n-type voltage sustaining region. The drift region 110 is formed on or over a semiconductor substrate. In this example, the drift region 110 comprises one or more epitaxial layers.

The substrate may comprise an n-type doped semiconductor material, such as n+ silicon. An n-dopant concentration of the substrate may be larger than about 5 × 10¹⁸ cm⁻³. The substrate is conductive and acts as a drain region 115. A height of the substrate may be between about 40 µm and about 100 µm. A drain contact 115a may be arranged on an underside of the substrate, e.g., a side of the substrate that is opposite to the drift region 110. The drain contact 115a may comprise a conductive material, such as a metal material.

The active area 105 includes a body region 120 of a second conductivity type. The second conductivity type is opposite to the first conductivity type. In the embodiment shown in Fig. 1, the body region 120 comprises a p-type semiconductor material. The body region 120 is arranged over or above the drift region 110.

The active area 105 includes a trench 125. The trench 125 is in contact with the body region 120 and the drift region 110. For example, the body region 120 is provided on either side of an upper part of the trench 125. The drift region 110 is provided on either side of a lower part of the trench 125 and between the trench 125 and the substrate, e.g., the drain region 115.

The trench 125 includes a source conductive region. The source conductive region is referred to in the following description as a trench shield 130.

The trench 125 includes a gate conductive region 135. A height of the body region 120 may be less than a height of the gate conductive region 135. This may allow for the gate conductive region 135 being able to provide switching along a full length of the body region 120.

The trench 125 includes a first insulation region 140a. The first insulation region is arranged between sidewalls of the trench 125 and between trench shield 130. For example, the trench shield insulation region 140a may be arranged between lower portions of the sidewalls of the trench 125 and the trench shield 130 and below the trench shield 130. The first insulation region 140a may also be referred to as a trench shield insulation region 140a.

The trench 125 includes a second insulation region 140b. The second insulation region 140b is arranged between the trench shield 130 and the gate conductive region 135. The second insulating region 140b may also be referred to as an inter-poly oxide region 140b.

The trench 125 includes a third insulation region 140c. The third insulation region 140c is arranged between the sidewalls of the trench 125 and the gate conductive region 135. For example, the third insulation region 140c may be arranged between upper portions of the sidewalls of the trench 125 and the gate conductive region 135 and over or above the gate conductive region 135. The third insulation region 140c may also be referred to as a gate oxide region 140c.

The device 100, e.g., the active region 105, may comprise a fourth insulation region 140d. The fourth insulation region 140d is arranged above or over the gate conductive region 135. For example, the fourth insulation region 140d may be arranged on an upper portion of the gate oxide region 140c. The fourth insulation region may also be referred to as an interlayer dielectric layer 140d.

The trench shield 130 and the gate conductive region 135 may each be formed from a conductive material, such as a metal or a doped semiconductor material. For example, the doped semiconductor material may comprise doped polysilicon. The metal material may comprise a rare metal material, such as Tungsten. The trench shield 130 and the gate conductive region 135 may both be formed from the same doped semiconductor material. Alternatively, the trench shield 130 may be formed from the doped semiconductor material and the gate conductive region 135 may be formed from the metal material.

The device 100 includes a source contact region, which in this example is an n+ source contact 145 region. The n+ source contact region 145 is arranged above the body region 120 and on either side of the trench 125 and the gate conductive region 135. For example, the n+ source contact region 145 is arranged above the body region 120 and on either side of the gate oxide region 140c. During operation, a conduction channel is formed between the n+ source contact region 145 and the drift region 110 by application of a positive voltage to the gate conductive region 135.

The body region 120 comprises a contact region, which in this example is a p+ contact region 150. The p+ contact region 150 is formed below a contact opening or recess 152 that is formed on either side of the trench 125 and the gate conductive region 135.

The device 100 may also include a source contact 154. A first part 154a of the source contact 154 may extend into each contact opening or recess 152. The first part 154a of the source contact may be arranged to contact the n+ source contact 145 region and the p+ contact region 150.The first part 154a of the source contact 154 may comprise a conductive material, such as a metal material. The metal material may comprise tungsten, titanium or a combination thereof, such as a stack of at least one layer of tungsten and at least one layer of titanium. A second part 154b of the source contact 154 is arranged on the interlayer dielectric layer 140d. The second part 154b of the source contact 154 may comprise a conductive material, such as a metal material. The metal material may comprise aluminum or the like.

A width of the gate oxide region 140c between the gate conductive region 135 and each of the sidewalls of the trench 125 is smaller than a width of the trench shield insulation region 140a between the trench shield 130 and each of the sidewalls of the trench 125. The relatively smaller width of the gate oxide region 140c between the gate conductive region 135 and each of the sidewalls of the trench 125 allows the gate conductive region 135 to act as a gate, e.g., when a small positive voltage of about 5 V to 10 V is applied to the gate conductive region 135. The width of the gate oxide region 140c can be selected such that a breakdown of the gate oxide region 140c is prevented, e.g., when the voltage is applied to the gate conductive region 135. For example, the width of the gate oxide region 140c may be selected such that the gate oxide region 140c withstands a voltage of about 20V applied to the gate conductive region 135.

The width of the trench shield insulation region 140a between the trench shield 130 and each of the sidewalls of the trench 125 is selected such that a breakdown of the trench shield insulation region 140a is prevented, e.g., when a voltage is applied to the drain region 115 and the trench shield 130. For example, during operation, the trench shield 130 and the source contact 154 are at source potential. As the voltage applied to the drain region 115 and the trench shield 130 is larger than the voltage applied to the gate conductive region 135, the width of the trench shield insulation region 140a between the trench shield 130 and each of the sidewalls of the trench 125 is typically larger than the width of the gate oxide region 140c between the gate conductive region 135 and each of the sidewalls of the trench 125. For example, the voltage that may be applied to the drain region 115 and the trench shield 130 may be in the region of about 100 V to 200 V.

In an example, the drain voltage at the drain region 115 may be 100V. The source voltage on the trench shield 130 and the source contact region 145 may be 0V. The gate voltage on the gate conductive region 135 may vary from 0V to 10V. Thus, Vds across the trench shield insulation region 140a could be 100V, and as a result the trench shield insulation region 140a needs to be thick. Vgs across the gate oxide region 140c is only about 10V, thus can be much thinner. Vgs across the second insulation region 140b is also max 10V, but this oxide may be of a poorer quality as it is not grown on crystalline silicon, this it is generally thicker than the gate oxide region 140c.

During operation, a charge Q_{gd} between the gate conductive region 135 and the drain region 115 can affect a switching efficiency of the device 100. This charge can be derived from an inherent capacitance between the gate conductive region 135 and the drain region 115 and has two components, namely Q_{gd1} and Q_{gd2}, which are indicated in Fig. 1. The first component Q_{gd1} may be considered as a charge due to a capacitance across gate oxide region 140c between the gate conductive region 135 and the drift region 110. The second component Q_{gd2} may be considered as a charge due to a capacitance between the gate conductive region 135 and the drift region 110 across the inter-poly oxide region 140b and a part of the trench shield insulation region 140a. The inventors have found that Q_{gd2} plays an important role and it is desirable to reduce a value of Q_{gd2}, e.g., in order to improve the switching efficiency of the device.

Fig. 1 also shows a charge Q_{gs} due to a capacitance between the gate conductive region 135 and the trench shield 130 and due to a capacitance between the gate conductive region 135 and the n+ source region 145. This charge comprises a first component Q_{gs1} and a second component Q_{gs2}, which are indicated in Fig. 1. The first component Q_{gs1} may be considered as a charge due to the capacitance between the gate conductive region 135 and the n+ source region 145. The second component Qgs2 may be considered as a charge due to the capacitance between the gate conductive region 135 and the trench shield 130 across the inter-poly oxide region 140b.

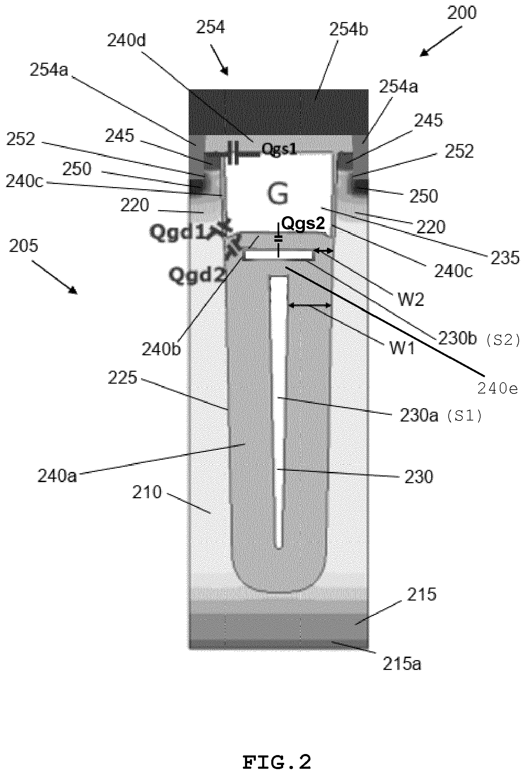

The present disclosure presents an improved semiconductor device. The improved semiconductor device includes a segmented-poly trench MOSFET, such as shown in Fig. 2. Segmentation of the shield source reduces the Q_{gd}, resulting in an improved Q_{gd}*R_{ds} Figure of Merit (FOM). Since the Q_{gs} is increased concurrently, the Q_{gd}/Q_{gs} ratio may also be reduced, making the semiconductor device more immune to gate bounce.

Fig. 2 schematically shows a cross section of an active region 205 of a semiconductor device 200 according to an embodiment of the disclosure. The semiconductor device 200 shown in Fig. 2 may comprise any of the features of the semiconductor device 100 shown in Fig. 1. Only differences will be described in the following.

Fig. 2 shows a segmented-poly trench MOSFET, wherein the shield source is separated into two parts: S1 230a is to mainly perform the field-plate effect for a better Rds vs. BVDSS trade-off; and S2 230b is to act as a shield to block the electrical lines between the gate and drain electrodes. The first part 230a and the second part 230b form a segmented trench shield 230. The first part 230a of the segmented trench shield 230 may also be referred to as a pillar portion. The second part 230b of the segmented trench shield 230 may also be referred to as a shield portion. The segmented trench shield 230 may also be referred to as a segmented source conductive region.

The segmented trench shield 230 is arranged such that the second part 230b of the segmented trench shield 230 is arranged between the first part 230a of the segmented trench shield 230 and the gate conductive region 235. Moreover, the first part 230a of the segmented trench shield 230 is separated from the second part 230b of the segmented trench shield 230 by an inter-poly oxide region 240e.

The segmented trench shield 230 may be configured such that a first width W1 of the trench shield insulation region 240a between each of the sidewalls of the trench 225 and the first part 230a of the segmented trench shield 230 is larger than a second width W2 of the trench shield insulation region 240a between each of the sidewalls of the trench 225 and the second part 230b of segmented trench shield 230. For example, the first width W1 may be between about 0.1 µm and 2 µm. The second width W2 may be between about 5% and 95% of the first width W1.

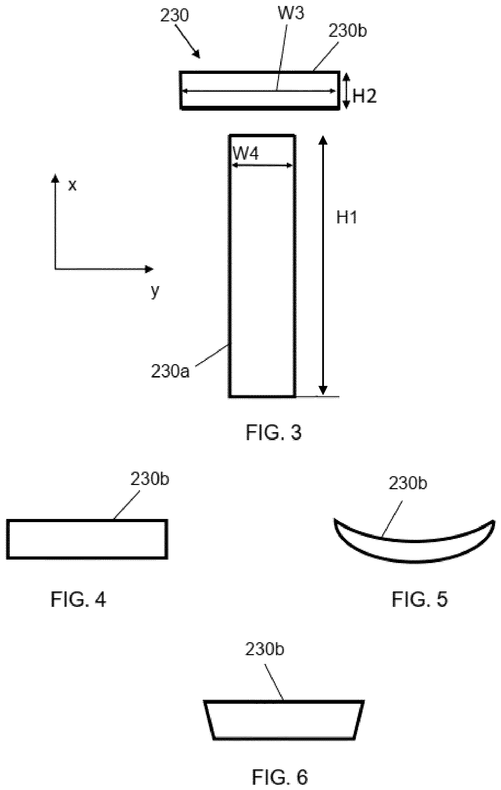

An example segmented trench shield 230 that may be part of the device 200 is schematically shown in Fig. 3. A height H2 of the second part 230b may be between 0.05 µm and 1/5 of a height H1 of the first part 230a of the segmented trench shield 230. The height H2 of the second part 230b and the height H1 of the first part 230a of the segmented trench shield 230 are indicated in Fig. 3.

By providing the segmented trench shield 230 with the second part 230b, as described above, an area of a capacitor formed between the gate conductive region 235 and the drift region 210 across the inter-poly oxide region 240b and the trench shield insulation region 240a may be reduced. As the capacitance of the capacitor is proportional to the area, the second component Q_{gd2} of the charge Q_{gd} between the gate conductive region 235 and the drain region 215 is reduced. As such, the second part 230b of the segmented trench shield 230 may be considered as shielding the drain region 215 from the gate conductive region 235. Expressed differently, the second part 230b of the segmented trench shield 230 may be configured to reduce or prevent the formation of electrical field lines between gate conductive region 235 and the drain region 215. This may result in a reduction of the second component Q_{gd2} of the charge Q_{gd} between the gate conductive region 235 and the drain region 215, which may result in a reduction of the total charge Q_{gd} between the gate conductive region 235 and the drain region 215. This in turn may lead to an improved FOM, which equals the product of a resistance of the device 200 and the total charge between the gate conductive region 235 and the drain region 215. The FOM is indicative of a conduction loss and switching loss of the device 200. For example, the inventors have found that the total charge Q_{gd} between the gate conductive region 235 and the drain region 215 determined for the device 200 shown in Fig. 2 may be reduced by more than 50% relative to the total charge Q_{gd} between the gate conductive region 135 and the drain region 115 determined for the device 100 shown in Fig. 1. The FOM determined for the device 200 shown in Fig. 2 may be reduced by more than 40% relative to the FOM determined for the device 100 shown in Fig. 1. The reduction of the FOM is indicative of an improved switching efficiency and reduced energy loss of the device 200 shown in Fig. 2 relative to the device 100 shown in Fig. 1.

In the device 200 shown in Fig. 2, an area of a capacitor between the gate conductive region 235 and the segmented trench shield 230 is increased, e.g., relative to an area of a capacitor between the gate conductive region 135 and the trench shield 130 of the device 100 shown in Fig. 1. As such, the second component Q_{gs2} of the charge Q_{gs} due to the capacitance between the gate conductive region 235 and the second part 230b of the segmented trench shield 230 and due to the capacitance between the gate conductive region 235 and the n+ source region 245 of the device 200 shown in Fig. 2 is increased relative to the second component Q_{gs2} of the same charge Q_{gs} of the device 100 shown in Fig. 1. As such, a ratio Q_{gd2}/Q_{gs2} of the second component Q_{gd2} of the charge Q_{gd} between the gate conductive region 235 and the drain region 215 and the second component Q_{gs2} of the charge Q_{gs} due to the capacitance between the gate conductive region 235 and the segmented trench shield 230 and due to the capacitance between the gate conductive region 235 and the n+ source region 245 determined for the device 200 shown in Fig. 2 is decreased relative to the same ratio determined for the device 100 shown in Fig. 1. Accordingly, a ratio Q_{gd}/Q_{gs} of the total charge Q_{gd} between the gate conductive region 235 and the drain region 215 and the total charge Q_{gs} due to the capacitance between the gate conductive region 235 and the segmented trench shield 230 and due to the capacitance between the gate conductive region 235 and the n+ source region 245 determined for the device 200 shown in Fig. 2 is reduced by about 50% relative to the same ratio determined for the device 100 shown in Fig. 1. This reduction of this ratio may lead to a reduced gate bounce effect. The gate bounce effect may be due a capacitively coupled voltage at the gate conductive region of the device exceeding a threshold voltage of the device. This voltage can cause the conduction channel between the n+ source contact region and the drift region to be formed and may prevent the device from being turned off. The capacitively coupled voltage at the gate conductive region of the device may be due a large rate of increase of a voltage at the drain region during switching operation of the device. By reducing the second component Q_{gd2} of the charge Q_{gd} between the gate conductive region 235 and the drain region 215 and/or increasing the second component Q_{gs2} of the charge Q_{gs} due to the capacitance between the gate conductive region 235 and the segmented trench shield 230 and due to the capacitance between the gate conductive region 235 and the n+ source region 245, as described above, the increase of the capacitively coupled voltage at the gate conductive region 235 with increasing voltage at the drain region 215 may be reduced or suppressed.

As such, the device 200 shown in Fig. 2 can be considered as having an improved total efficiency relative to the device 100 shown in Fig. 1.

By configuring the trench shield 235 such that the height H2 of the second part 230b is between 0.05 µm and 1/5 of the height H1 of the first part 230a of the segmented trench shield 230, an effect of the second part 230b of the segmented trench shield 230, e.g., on a breakdown voltage of the device 200, may be reduced or prevented. The breakdown voltage of the device 200 may be understood as the maximum voltage that can be applied between the drain region 215 and the n+ source region 245 (and the segmented trench shield 230) without causing damage to the device 200. As such, this configuration of the segmented trench shield 230 may be considered as allowing for the improved device performance, as described above, while simultaneously reducing or preventing any other effects on the device 200 that may be due to the second part 230b of the segmented trench shield 230.

Referring back to Fig. 2 and Fig. 3, the segmented trench shield 230 may be configured such that the second part 230b of the segmented trench shield 230 extends in a direction across the sidewalls of the trench 225 and the first part 230a of the segmented trench shield 230 extends in a direction parallel, e.g., substantially parallel, to the sidewalls of the trench 225. For example, the first part 230a of the segmented trench shield 230 may extend in a first or x-direction. The first or x-direction may also be understood as a direction from the body region 220 to the drift region 210 or substrate, e.g., drain region 215, and/or parallel to the sidewalls of the trench 225. The second part 230b of the segmented trench shield 230 may extend in a second or y-direction. The second or y-direction is perpendicular, e.g., substantially perpendicular, to the first or x-direction. The second or y-direction can also be understood as a lateral direction of the device 200. The first or x-direction and the second or y-direction are indicated by a coordinate system in Fig. 3.

In an example, the width W3 of the second part 230b of the segmented trench shield 230 may be between about 0.3 µm and about 4.9 µm.

In an example, the height H1 of the first part 230a of the segmented trench shield 230 may be between about 0.1 µm and about 10 µm. A width W4 of the first part 230a of the segmented trench shield 230 may be between about 0.05 µm and about 1 µm.

Referring to Fig. 2, the first width W1 of the trench shield insulation region 240a between each sidewall of the trench 225 and the first part 230a of the segmented trench shield 230 may be generally uniform along the height H1 of the first part 230a of the segmented trench shield 230. This may facilitate an adjustment of a doping profile of the drift region 210, e.g., to achieve one or more desired device properties, such as desired breakdown voltage and/or ON-state resistance. In examples, where the first width W1 of the trench shield insulation region 240a varies, an adjustment of the doping profile of the drift region 210 may be required to achieve the desired device properties.

The second part 230b of the segmented trench shield 230 may be formed having different shapes. Fig. 4, Fig. 5 and Fig. 6 each schematically show an example shape of the second portion 230b of the segmented trench shield 230 shown in Fig. 2 or Fig. 3.

In an example embodiment, S1 230a and S2 230b may be common, i.e., biased the same.

In another example, the S2 230b bias voltage may be different from the S1 230a bias, e.g., positively biased at on-state to gain a lower Rdson and ground at off-state to avoid impacting BVDSS performance. Thus, FOM may be further improved.

The process flow of manufacturing a semiconductor device according to the present disclosure, such as semiconductor device 200, is compatible with existing manufacturing processes, such as an SGT-MOSFET manufacturing process, with the addition of the creation of the inter-poly oxide region 240e and the segmented trench shield 230 including the first part 230a separated by the inter-poly oxide region 240e from the second part 230b.

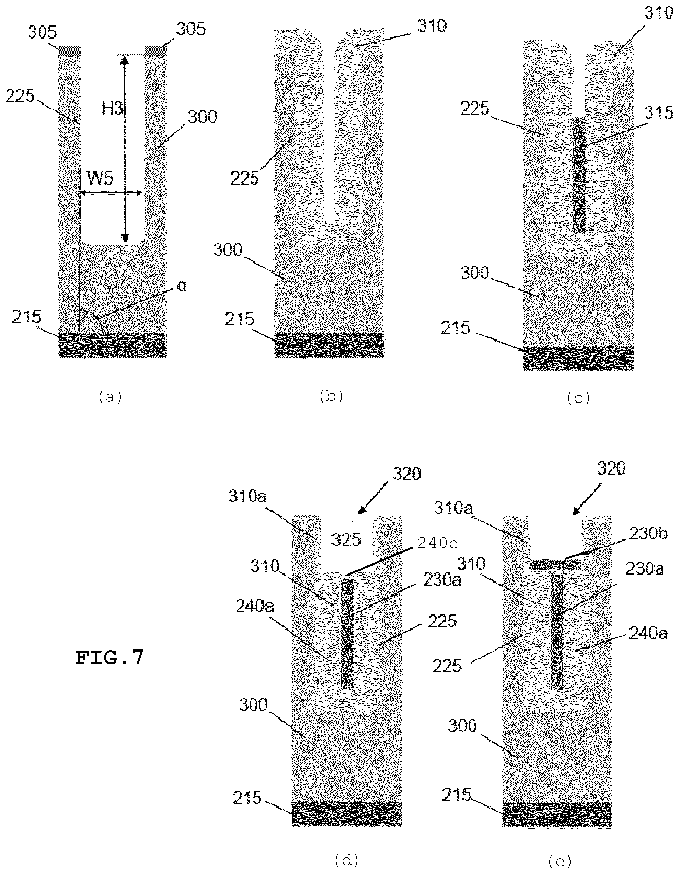

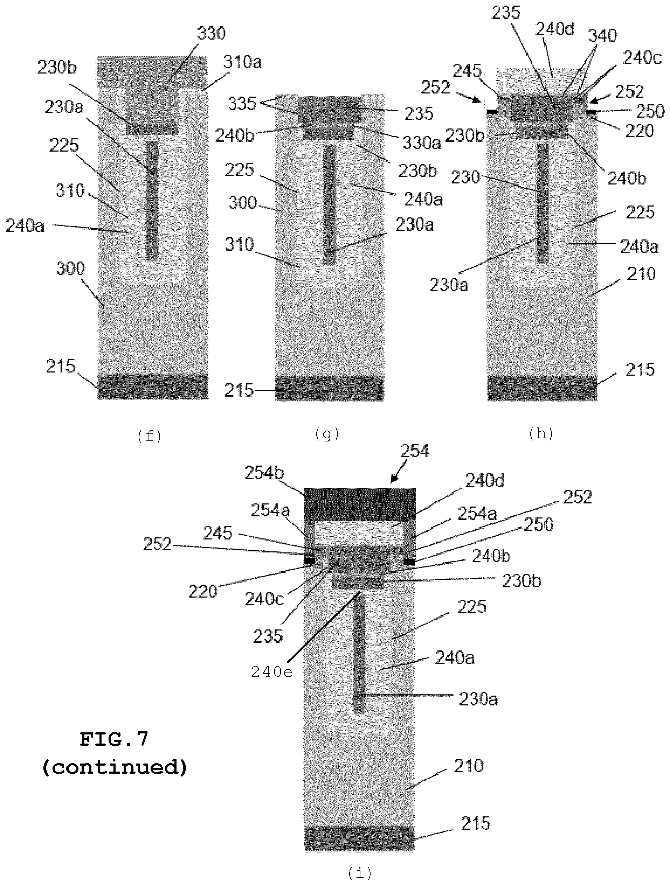

Figs. 7(a) to (i) shows steps of a method of manufacturing an active region of a semiconductor power device according to an example embodiment of the disclosure, such as the active region 205 of the device 200 described above. Many of the features are the same as those shown in Fig. 2 and therefore carry the same reference numerals. It will be appreciated that the steps shown in Fig. 7 may illustrate a subset of all the steps for manufacturing a device, and that the method may further include additional steps preceding or following the steps of Fig. 7. Whilst Fig. 7 shows steps in manufacturing an active area having one trench 225, it will be understood that the method may be used to manufacture more than one trench.

In step (a), the method may comprise forming the trench 225 in a semiconductor region 300. The semiconductor region 300 may comprise the drift region 210. The body region 220 may be formed in the semiconductor region 300, as will be described below. The semiconductor region includes one or more epitaxial layers that have been formed on the substrate, e.g., drain region 215. The trench 225 may be formed by depositing a layer of mask material 305 on the semiconductor region 300. The mask material may comprise an oxide material, such as TEOS (tetraethyl orthosilicate), a nitride material, such as Si3N4, or a combination thereof, such as a stack of a layer of TEOS and a layer of the nitride material. The layer of mask material 305 may be patterned, e.g., using a material removal process, such as a dry-etch process or a wet-etch process. The patterned layer of mask material may act as a hard mask or resists layer to define the trench 225 during a material removal process, such as a dry-etch process, to form the trench 225 in the semiconductor region 300.

Subsequent to the formation of the trench 225, the layer of mask material may be removed, e.g., using a material removal process, such as a wet-etch process. The trench 225 may comprise a height H3 between about 0.1 µm and about 20 µm. The trench 225 may comprise a width W5 between about 0.3 µm and about 5 µm. The sidewalls may be formed at an angle α relative to a surface of the substrate, e.g., drain region 215. The angle may be between about 80 degrees and about 90degrees.

In steps (b) and (c), the method may comprise forming the trench shield insulation region 240a in the trench 225.

In step (b), a first layer of insulating material 310 may be deposited on inner walls of the trench 225 and on the semiconductor region 300, e.g., an upper surface thereof, e.g., using a deposition process. The inner wall of the trench 225 include the sidewalls and lower inner wall of the trench 225. The first layer of insulating material 310 may act as a liner of the trench 225. The insulating material may comprise an oxide material, such as Silicon Dioxide (SiO2). In other embodiments, the insulating material may comprise an oxide material having a dielectric constant that is higher than a dielectric constant of SiO2. For example, in such other embodiments, the oxide material may comprise Hafnium oxide (HfO2).

In steps (c) to (e), the method may comprise forming the segmented trench shield 230. For example, in steps (c) and (d), the method may comprise forming the first part 230a of the segmented trench shield 230. The first part 230a of the segmented trench shield 230 may be formed by depositing a layer of conductive material 315 on the first layer of insulating material 310 in the trench 225, e.g., using a deposition process. The method comprises partially removing the layer of conductive material 315 such that a height of the layer of conductive material 315 is less than the height H3 of the trench 225. The layer of conductive material 315 may be partially removed by using a material removal process, such as a dry-etch process. The conductive material may comprise a doped semiconductor material, such as polysilicon.

In step (d), the method may comprise partially removing the first layer of insulating material 310 from an upper part 320 of the trench 225. The upper part of the trench 225 may also be referred to as an open-end portion of the trench. The remaining part of the first layer of insulating material 310 may have a thickness that is less than a thickness of the first layer of insulating material 310 in a lower part of the trench 225. The first layer of insulating material 310 in the lower part of the trench 225 forms the trench shield insulation region 240a. The thus formed cavity or recess 325 may be refilled with the insulating material, e.g., comprising the oxide material, and the insulating material may subsequently be partly removed by using a material removal process, e.g., including a polishing process and an etch back process, to form the trench shield insulation region 240a.

In step (e), the method may comprise forming the second part 230b of the segmented trench shield 230. The method may comprise depositing a layer of conductive material 315 into the cavity or recess 325 on top of the trench shield insulation region 240a, e.g., using a deposition process and typically after TEOS deposition and densification. This may facilitate the manufacture of the device 200. Subsequently to depositing the layer of conductive material 315 into the cavity or recess 325, the layer of conductive material 315 may be partially removed, e.g., using a material removal process, such as a dry-etch process, to form the second part 230b of the segmented trench shield 230. For example, a remainder of the layer of conductive material 315 may form the second part 230b of the trench shield.

In steps (f) and (g), the method may comprise forming the inter-poly oxide region 240b and the gate conductive region 235. For example, in step (f), the method may comprise depositing a second layer of insulating material 330 on the second part 230b of the segmented trench shield 230, e.g., using a deposition process. The insulating material may comprise an oxide material, such as Silicon Dioxide (SiO2). The second layer of insulating material 330 may be deposited to fill the upper part 320 of the trench 225.

In step (g), the method may comprise partially removing the second layer of insulating material 330 such that a part 330a of the second layer of insulating material 330 remains on the second part 230b of segmented trench shield 230. The part 330a of the second layer of insulating material forms the inter-poly oxide region 240b. The method may also comprise removing the part 310a of the first layer of insulating material 310 from an upper portion of both the sidewalls of the trench 225 and an upper surface of the semiconductor region 300. The second layer of insulating material 330 and the part 310a of the first layer of insulating material 310 may be removed by using a material removal process, e.g., including a polishing process and a dry-etch or wet-etch process. The inter-poly oxide region 240b and the trench shield insulation region 240a may define a surface on which the gate conductive region 235 may be formed.

The method may comprise forming a third layer of insulating material 335 along the upper portions of the sidewalls of the trench 225 and an upper surface of the semiconductor region 300, e.g., by oxidizing the semiconductor region 300. For example, the upper portions of the sidewalls of the trench 225 may be exposed to air. The upper surface of the semiconductor region 300 may also be exposed to air. A thermal oxidation process may be used to form a part of the gate oxide region 240c on the exposed upper portions of the sidewalls of the trench 225 and the exposed upper surface of the semiconductor region 300. The thermal oxidation process may comprise a dry oxidation process, e.g., in a pure oxygen atmosphere, a wet oxidation process, such as a hydrothermal treatment, or a combination of the dry and wet oxidation processes. The third layer of insulating material 335 may define a part of the gate oxide region 240c.

The method may comprise depositing a layer of conductive material on the surface defined by the trench shield insulation region 240a and the inter-poly oxide region 240b, e.g., using a deposition process, to form the gate conductive region 235. The conductive material may be the same as or different to the conductive material of the segmented trench shield 230. The gate conductive region 235 may be planarized using a polishing process or a dry-etch process.

In step (h), the method may comprise forming the body region 220. The method may comprise forming a fourth layer of insulating material 340 on the gate conductive region 235 and the semiconductor region 300, e.g., to complete the gate oxide region 240c. The fourth layer of insulating material 340 may be formed on an upper surface of the gate conductive region 235 and the semiconductor region, e.g., by oxidizing the semiconductor region 300 and the gate conductive region 235. The fourth layer of insulating material 340 may be considered as part of the gate oxide region 240c.

The method may comprise implanting a p-type dopant (e.g., Boron) into the semiconductor region 300 below the fourth layer of insulating material 340 to form the body region 220. A p-dopant concentration of the body region 220 may be between about 10¹⁵ cm⁻³ and about 10¹⁸ cm⁻³.

The method may comprise implanting an n-type dopant (e.g., Phosphor or Arsenic) above the body region 220 and below the fourth layer of insulating material 340 to form the n+ source contact region 245. An n-dopant concentration of the n+ source contact region 245 may be larger than 5 × 10¹⁸ cm⁻³.

The method may comprise depositing a fifth layer of insulating material on the fourth layer of insulating material 340, e.g., using a deposition process. The fifth layer of insulating material may comprise an oxide material, such as TEOS (tetraethyl orthosilicate). The fifth layer of insulating material forms the interlayer dielectric layer 240d.

The method may comprise forming contact openings or recesses 252, e.g., using a material removal process, e.g., on either side of the gate conductive region 235. For example, the contact openings or recesses 252 may be formed by etching through the n+ source contact region 245, extending to the body region 220. A p-type dopant (e.g., Boron or Boron difluoride) may be implanted below each contact opening or recess 252 to form the p+ contact region 250. A p-dopant concentration of the p+ contact region 250 may be larger than 5 × 10¹⁸ cm⁻³.

In step (i), the method may comprise forming the source contact 254. For example, the source contact 254 may be formed by depositing a second layer of conductive material into each contact opening or recess, e.g., to form the first part 254a of the source contact 254. The method may comprise depositing a third layer of conductive material on the interlayer dielectric layer 240d, e.g., to form the second part 254b of the source contact 254.

The dry-etch process mentioned above may include a reactive ion etch process or another dry-etch process.

The deposition process mentioned above may comprise a chemical vapor deposition process or another deposition process.

The polishing process mentioned above comprises a chemical mechanical polishing process or another polishing process.

It will be appreciated that manufacturing process of Fig. 7 may be performed differently whilst creating the semiconductor device of the present disclosure, such as semiconductor device 200 and in particular comprising the inter-poly oxide region 240e and the segmented trench shield 230 including the first part 230a separated by the inter-poly oxide region 240e from the second part 230b.

It will be appreciated that the term "width" used herein encompasses a size, dimension or extension of a part or feature in a lateral direction, e.g., the y-direction in Fig. 3.

It will be appreciated that the term "height" used herein encompasses a size, dimension or extension of a part or feature in a longitudinal direction, e.g., the x-direction in Fig. 3 and/or a direction perpendicular to the lateral direction.

The skilled person will understand that in the preceding description and appended claims, positional terms such as 'above', 'overlap', 'under', 'lateral, etc. are made with reference to conceptual illustrations of an apparatus, such as those showing standard cross-sectional perspectives and those shown in the appended drawings. These terms are used for ease of reference but are not intended to be of limiting nature. These terms are therefore to be understood as referring to a device when in an orientation as shown in the accompanying drawings.

It will be appreciated that all doping polarities mentioned above could be reversed, the resulting devices still being in accordance with embodiments of the present invention.

Although the above description refers to the device comprising a MOSFET, it will be appreciated that in other embodiments the device may comprise an IGBT. Any of the above-mentioned features may also apply to the IGBT. In such other embodiments, the terms "drain region" may be replaced with the terms "collector region" and the term "source", as used above, may be replaced with the term emitter.

In this document, dimensions are provided merely as indicative examples, and are not intended to be limiting.

It will be appreciated that Figs. 1 to 7 are schematic drawings of some embodiments of the disclosure and may not be to scale.

Although specific embodiments have been described above, the claims are not limited to those embodiments. Those skilled in the art will be able to make modifications and alternatives in view of the disclosure, which are contemplated as falling within the scope of the appended claims. Each feature disclosed may be incorporated in any of the described embodiments, alone or in an appropriate combination with other features disclosed herein.

## Claims

1. A semiconductor power device (200) comprising an active region, the active region (205) comprising:
a drift region (210) of a first conductivity type;
a body region (220) of a second conductivity type provided over the drift region (210), wherein the second conductivity type is opposite to the first conductivity type; and
a trench (225) in contact with the body region (220) and the drift region (210), the trench (225) comprising:
a gate conductive region (235);
a segmented source conductive region (230) comprising first part (230a) and a second part (230b), the first part (230a) being separated from the second part (230b) by a first insulation region (240e), the second part (230b) of the segmented source conductive region (230) being arranged between the gate conductive region (235) and the first part (230a) of the segmented source conductive region (230);
a second insulation region (240a) arranged between the segmented source conductive region (230) and sidewalls of the trench (225);
a third insulation region (240b) arranged between the segmented source conductive region (230) and the gate conductive region (235); and
wherein the segmented source conductive region (230) is configured such that a first width (W1) of the second insulation region (240a) between each of the sidewalls of the trench (225) and the first part (230a) of the segmented source conductive region (230) is larger than a second width (W2) of the second insulation region (240a) between each of the sidewalls of the trench (225) and the second part (230b) of the segmented source conductive region (230).

2. The semiconductor power device (200) according to claim 1, wherein the segmented source conductive region (230) is configured such that the second part (230b) of the segmented source conductive region (230) extends in a direction across the sidewalls of the trench (225) and the first part (230a) of the segmented source conductive region (230) extends in a direction parallel to the sidewalls of the trench (225).

3. The semiconductor power device (200) according to any one of the preceding claims, wherein a width (W3) of the second part (230b) of the segmented source conductive region (230) is between 0.3 µm and 4.9 µm.

4. The semiconductor power device (200) according to any one of the preceding claims, wherein a width (W4) of the first part (230a) of the segmented source conductive region (230) is between 0.05 µm and 1 µm.

5. The semiconductor power device (200) according to any one of the preceding claims, wherein the second width (W2) is between 5% and 95% of the first width (W1).

6. The semiconductor power device (200) according to any one of the preceding claims, wherein the first width (W1) is between 0.1 µm and 2 µm.

7. The semiconductor power device (200) according to any one of the preceding claims,
wherein a height (H2) of the second part (230b) is between 0.05 µm and 1/5 of a height (H1) of the first part (230a) of the segmented source conductive region (230).

8. The semiconductor power device (200) according to claim 7, wherein the segmented source conductive region (230) is configured such that the second width (W2) is uniform along the height (H2) of the second part (230b) the segmented source conductive region (230) or varies along the height (H2) of the second part (230b) of the segmented source conductive region (230).

9. The semiconductor power device (200) according to any one of the preceding claims, wherein a shape of the second part (230b) of the segmented source conductive region (230) comprises at least one of: a quadrilateral shape and/or a rounded shape.

10. The semiconductor power device (200) according to any one of the preceding claims, wherein the semiconductor device comprises a metal-oxide-semiconductor field-effect transistor (MOSFET) or an insulated-gate bipolar transistor (IGBT).

11. A method of manufacturing an active region (205) of a semiconductor power device (200), the method comprising:
forming a trench (225) in a semiconductor region (300);
forming a first insulation region in the trench (225);
forming a segmented source conductive region (230) in the trench (225) such that the second insulation region (240a) is arranged between the segmented source conductive region (230) and sidewalls of the trench (225), the segmented source conductive region (230) comprising a first part (230a) and a second part (230b), wherein the segmented source conductive region (230) is formed such that the first part (230a) is separated from the second part (230b) by a first insulation region (240e), wherein the segmented source conductive region (230) is formed such that a first width (W1) of the second insulation region (240a) between each of the sidewalls of the trench (225) and the first part (230a) of the segmented source conductive region (230) is larger than a second width (W2) of the second insulation region (240a) between each of the sidewalls of the trench (225) and the second part (230b) of the segmented source conductive region (230);
forming a third insulation region (240b) on the second part (230b) of the segmented source conductive region (230); and
forming a gate conductive region (235) in the trench (225) such that the second part (230b) of the segmented source conductive region (230) is arranged between the gate conductive region (235) and the first part (230a) of the segmented source conductive region (230).

12. The method according to claim 11, wherein a height (H2) of the second part (230b) is between 0.05 µm and 1/5 of a height (H1) of the first part (230a) of the segmented source conductive region (230).

13. The method according to claim 12, wherein forming the segmented source conductive region (230) in the trench (225) comprises forming the first part (230a) of the segmented source conductive region (230), wherein forming the first part (230a) of the segmented source conductive region (230) comprises:
depositing a layer of conductive material (315) on the layer of insulating material (310) and partially removing the layer of conductive material such that a height of the layer of conductive material is less than a height of the trench (225);
partially removing the layer of insulating material (310) to expose a part of the layer of conductive material; and
removing the exposed part of the layer of conductive material to form a cavity or recess (325) in an upper part (320) of the trench (225).

14. The method according to claim 13, wherein forming the segmented source conductive region (230) in the trench (225) comprises forming the second part (230b) of the segmented source conductive region (230), wherein forming the second part (230b) of the segmented source conductive region (230) comprises:
creating a layer of insulating material (310) in the cavity or recess (325) formed in the upper part (320) of the trench (225), the layer of insulating material (310) covering the first part (230) of the segmented source conductive region (230);
depositing a layer of conductive material (315) in the cavity or recess (325) formed in the upper part (320) of the trench (225);
partially removing the layer of conductive material to form the second part (230b) of the segmented source conductive region (230).

15. A method of manufacturing a semiconductor power device (200) comprising:
manufacturing an active region (205) of the semiconductor power device (200) according to any one of claims 11 to 14.
